(19) Europäisches Patentamt
European Patent Office
Office européen des brevets

(11) **EP 4 716 230 A1**

(12) **EUROPEAN PATENT APPLICATION**
published in accordance with Art. 153(4) EPC

(43) Date of publication:
**25.03.2026 Bulletin 2026/13**

(21) Application number: **23943838.5**

(22) Date of filing: **26.09.2023**

(51) International Patent Classification (IPC):
**H04N 25/611** (2023.01)   **H04N 25/13** (2023.01)
**H04N 23/54** (2023.01)   **H04N 23/55** (2023.01)
**H10F 39/12** (2025.01)

(52) Cooperative Patent Classification (CPC):
**H04N 23/54; H04N 23/55; H04N 25/13;
H04N 25/611**

(86) International application number:
**PCT/KR2023/014910**

(87) International publication number:
**WO 2025/005345 (02.01.2025 Gazette 2025/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.06.2023   KR 20230084221
16.08.2023   KR 20230107136**

(71) Applicant: **Samsung Electronics Co., Ltd.
Suwon-si, Gyeonggi-do 16677 (KR)**

(72) Inventors:
• **KANG, Hwayong
Suwon-si, Gyeonggi-do 16677 (KR)**
• **SHIN, Jeongkil
Suwon-si, Gyeonggi-do 16677 (KR)**

(74) Representative: **HGF
HGF Limited
4th Floor, 1 City Square
Leeds LS1 2ES (GB)**

(54) **IMAGE SENSOR FOR CORRECTING CHROMATIC ABERRATION, CAMERA, AND ELECTRONIC DEVICE**

(57)     Provided are an image sensor for correcting chromatic aberration, a camera, and an electronic device. The image sensor comprises: a color filter layer that includes a plurality of color filters including at least one color channel and disposed on one plane of the image sensor; a microlens layer including a plurality of microlenses disposed on the upper end of the color filters; and a photosensitive element layer including a plurality of photosensitive elements corresponding to the plurality of color filters. The plurality of microlenses may be set to different heights to match the focal lengths of the color channels of light corresponding to the color filters on the basis of data on chromatic aberration according to the color channels of the light. Various other embodiments are possible.

FIG. 2

**Description**

[Technical Field]

Embodiments of the disclosure relate to an image sensor, a camera, and an electronic device for correcting chromatic aberration.

[Background Art]

A camera includes a lens and an image sensor. The lens collects incident light, and the image sensor may convert an amount of light incident per pixel from the light incident through the lens into charges and may collect image information based on the converted amount of charges. For example, the image sensor may include a charge-coupled device (CCD) or a complementary metal-oxide-semiconductor (CMOS). A signal corresponding to the amount of charges converted in the image sensor is transmitted to an image signal processor (ISP), and the ISP may identify an image based on the signal of the amount of charges.

The light incident through the lens may include various wavelengths. The light may have different refractive indices depending on the wavelength. The incident light may be refracted when passing through the lens, and chromatic aberration may occur due to a difference in refractive indices. The chromatic aberration may include axial chromatic aberration in which focal lengths differ depending on refractive indices and longitudinal chromatic aberration in which focal positions differ depending on refractive indices.

The above-described information may be provided as related art for the purpose of helping to understand the disclosure. No claim or determination is made as to whether any of the foregoing may be applied as prior art with respect to the disclosure.

[Disclosure of Invention]

[Solution to Problem]

According to various embodiments of the disclosure, an image sensor may include a color filter layer including a plurality of color filters including at least one color channel, the plurality of color filters being disposed on one plane of the image sensor, a microlens layer disposed on an upper side of the color filter layer and including a plurality of microlenses, and a photosensitive element layer including a plurality of photosensitive elements corresponding to the plurality of color filters. The plurality of microlenses may be configured to have different heights so as to match focal lengths of the color channels of light corresponding to the color filters based on chromatic aberration data according to the color channels of light.

According to various embodiments of the disclosure, a camera may include a lens, and an image sensor. The image sensor may include a color filter layer including a plurality of color filters including at least one color channel, the plurality of color filters being disposed on one plane of the image sensor, a microlens layer disposed on an upper side of the color filter layer and including a plurality of microlenses, and a photosensitive element layer including a plurality of photosensitive elements corresponding to the plurality of color filters. The plurality of microlenses may be configured to have different heights so as to match focal lengths of the color channels of light corresponding to the color filters based on chromatic aberration data according to the color channels of light incident through the lens.

According to various embodiments of the disclosure, an electronic device may include a camera, and at least one processor configured to control the camera. The camera may include a lens, and an image sensor. The image sensor may include a color filter layer including a plurality of color filters including at least one color channel, the plurality of color filters being disposed on one plane of the image sensor, a microlens layer disposed on an upper side of the color filter layer and including a plurality of microlenses, and a photosensitive element layer including a plurality of photosensitive elements corresponding to the plurality of color filters. The plurality of microlenses may be configured to have different heights so as to match focal lengths of the color channels of light corresponding to the color filters based on chromatic aberration data according to the color channels of light incident through the lens.

[Brief Description of Drawings]

FIG. 1 is a block diagram of an electronic device according to various embodiments in a network environment.
FIG. 2 is a view illustrating a configuration of a camera according to various embodiments.
FIG. 3 is a diagram illustrating chromatic aberration due to a lens and color channels according to various embodiments.
FIGS. 4A, 4B, 4C, and 4D are diagrams illustrating structures of a camera according to various embodiments.
FIGS. 5A and 5B are views illustrating microlenses for correcting axial chromatic aberration according to various embodiments.
FIGS. 6A and 6B are views illustrating an arrangement of color filters according to various embodiments.
FIGS. 7A and 7B are views illustrating longitudinal chromatic aberration according to various embodiments.
FIGS. 8 and 9 are views illustrating microlenses for correcting longitudinal chromatic aberration according to various embodiments.

[Mode for the Invention]

Hereinafter, various example embodiments of the disclosure will be described in greater detail with reference to the drawings. However, the disclosure may be implemented in various different forms and is not limited to the example embodiments described herein. In relation to the description of the drawings, the same or similar reference numerals may be used for the same or similar components. In addition, in the drawings and related descriptions, descriptions of well-known functions and configurations may be omitted for clarity and conciseness.

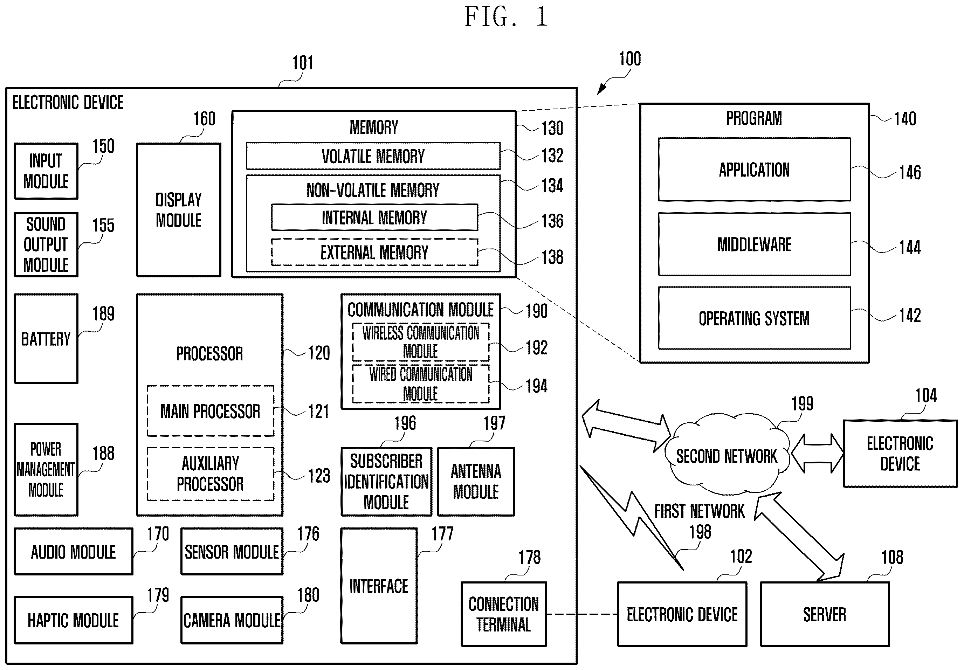

FIG. 1 is a block diagram illustrating an electronic device 101 in a network environment 100 according to various examples. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an example, the electronic device 101 may communicate with the electronic device 104 via the server 108. According to an example, the electronic device 101 may include a processor 120, memory 130, an input module 150, a sound output module 155, a display module 160, an audio module 170, a sensor module 176, an interface 177, a connection terminal 178, a haptic module 179, a camera module 180, a power management module 188, a battery 189, a communication module 190, a subscriber identification module (SIM) 196, or an antenna module 197. In some examples, at least one of the components (e.g., the connection terminal 178) may be omitted from the electronic device 101, or one or more other components may be added in the electronic device 101. In some examples, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one example, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an example, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an example, the auxiliary processor 123 (e.g., an image signal processor or a communication processor) may be implemented as part of another component (e.g., the camera module 180 or the communication module 190) functionally related to the auxiliary processor 123. According to an example, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134. The non-volatile memory may include at least one of an internal memory 136 and an external memory 138.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an example, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an example, the display module 160 may include a touch sensor adapted to detect a touch, or a pressure sensor adapted to measure the intensity of force incurred by the touch.

The audio module 170 may convert a sound into an electrical signal and vice versa. According to an example, the audio module 170 may obtain the sound via the input module 150, or output the sound via the sound output module 155 or a headphone of an external electronic device (e.g., the electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an example, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an example, the interface 177 may include, for example, a high definition multimedia interface (HDMI), a universal serial bus (USB) interface, a secure digital (SD) card interface, or an audio interface.

The connection terminal 178 may include a connector via which the electronic device 101 may be physically connected with the external electronic device (e.g., the electronic device 102). According to an example, the connection terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an example, the haptic module 179 may include, for example, a motor, a piezoelectric element, or an electric stimulator.

The camera module 180 may capture a still image or moving images. According to an example, the camera module 180 may include one or more lenses, image sensors, image signal processors, or flashes.

The power management module 188 may manage power supplied to the electronic device 101. According to one example, the power management module 188 may be implemented as at least part of, for example, a power management integrated circuit (PMIC).

The battery 189 may supply power to at least one component of the electronic device 101. According to an example, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an example, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth™, wireless-fidelity (Wi-Fi) direct, or infrared data association (IrDA)) or the second network 199 (e.g., a long-range communication network, such as a legacy cellular network, a fifth generation (5G) network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a fourth generation (4G) network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the millimeter wave (mmWave) band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an example, the wireless communication module 192 may support a peak data rate (e.g., 20 gigabits per second (Gbps) or more) for implementing eMBB, loss coverage (e.g., 164 decibels (dB) or less) for implementing mMTC, or U-plane latency (e.g., 0.5 milliseconds (ms) or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an example, the antenna module 197 may include an antenna including a radiating element composed of a conductive material or a conductive pattern formed in or on a substrate (e.g., a printed circuit board (PCB)). According to an example, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an example, another component (e.g., a radio frequency integrated circuit (RFIC)) other than the radiating element may be additionally formed as part of the antenna module 197.

According to various examples, the antenna module 197 may form an mmWave antenna module. According to an example, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an example, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an example, all or some of operations to be executed at the electronic device 101 may be executed at one or more of the external electronic devices (e.g. electronic devices 102 and 104 or the server 108). For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an example, the external electronic device 104 may include an internet-of-things (IoT) device. The server 108 may be an intelligent server using machine learning and/or a neural network. According to an example, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various examples may be one of various types of electronic devices. The electronic devices may include, for example, a portable communication device (e.g., a smartphone), a computer device, a portable multimedia device, a portable medical device, a camera, a wearable device, or a home appliance. According to an example of the disclosure, the electronic devices are not limited to those described above.

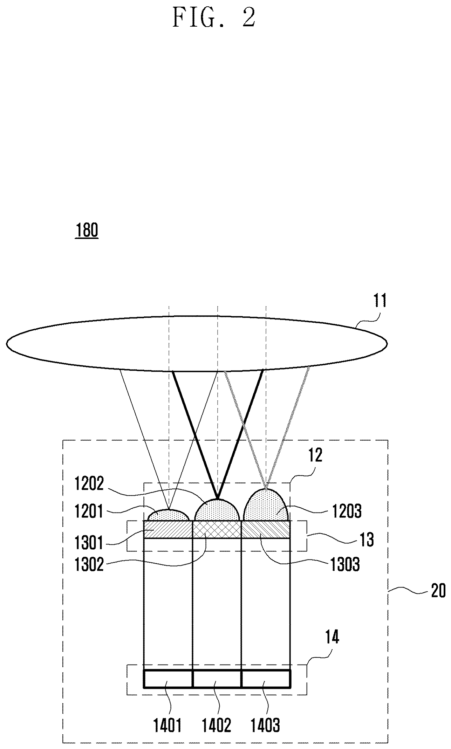

FIG. 2 is a view illustrating a configuration of a camera according to various embodiments.

Referring to FIG. 2, the camera 180 (e.g., the camera module 180 of FIG. 1) may include a lens 11 and an image sensor 20. The image sensor 20 may include a microlens layer 12, a color filter layer 13, and a photosensitive element layer 14.

The lens 11 may refract light incident from outside. In general, the lens needs to satisfy resolving power for the entire area of the image sensor 20 and also correct chromatic aberration. Therefore, the lens may be implemented as a plurality of lens groups. When the lens is implemented as a plurality of lens groups, the lens may become complicated, heavy, bulky, and costly. When chromatic aberration is corrected in the image sensor 20, a simpler lens may be used (e.g., without correcting chromatic aberration). The simpler lens may include a reduced number of lenses, and since it is easy to process, the yield of the lens may be improved. In addition, due to the increase in the yield of the lens, the cost of the lens may be reduced. Since the image sensor 20 of the disclosure may correct chromatic aberration, the structure of the lens of the camera 180 may be simplified. The lens 11 of the disclosure may include an objective lens. Alternatively, the camera 180 may include one or more simple lenses 11 according to a structure.

Light refracted by the lens 11 may be focused on a pixel portion, which is a photosensitive area of the image sensor 20 (e.g., the photosensitive element layer 14), through the microlens layer 12 of the image sensor 20. Accordingly, the photosensitive efficiency of the image sensor 20 may be maximized. Light incident through the lens 11 may have different refractive indices depending on wavelengths. Focal lengths of light may differ depending on refractive indices. In addition, the focal lengths of light may vary depending on characteristics of the lens 11. As an example, characteristics of the lens 11 may vary depending on a shape and and/or a physical property (or a material) of the lens.

As an example, when the lens 11 is a convex lens, a focal length of the convex lens may be as represented in Equation 1.

$$(n-1)(1/R1 - 1/R2) = 1/f \text{ -------------- } (1)$$

Here, n may be a refractive index of the lens 11, R1 may be a radius of curvature of one surface of the lens 11, R2 may be a radius of curvature of another surface of the lens 11, and f may be a focal length.

Therefore, the refractive index n of the lens 11 may vary depending on a physical property of the lens 11. When the refractive index n of the lens 11 varies, the focal length may also vary. In addition, when the lens 11 has a curved shape, the focal length may also vary depending on the radii of curvature R1 and R2 of both surfaces of the lens 11.

The camera 180 may include the image sensor 20, and the image sensor 20 may include the microlens layer 12, the color filter layer 13, and the photosensitive element layer 14.

The color filter layer 13 may include a plurality of color filters 1301, 1302, and 1303. Each of the plurality of color filters 1301, 1302, and 1303 may include one color channel and may receive light of a color corresponding to the color channel among incident light. As an embodiment, the color channel may include red, green, or blue, but is not limited thereto. The color filter layer 13 may be disposed on one plane below the microlens layer 12 and above the photosensitive element layer 14. The color filter layer 13 may be configured such that color filters including different color channels are disposed adjacent to each other. Alternatively, the color filter layer 13 may be configured such that a plurality of color filters including the same color channel are disposed to form an area. Each of the plurality of color filters 1301, 1302, and 1303 may correspond to one photosensitive element. One photosensitive element may constitute one pixel, and each of the plurality of color filters 1301, 1302, and 1303 may correspond to one pixel. Alternatively, the color filter layer 13 may be configured such that one color filter includes a plurality of pixels disposed adjacent to each other. In other words, one color filter may correspond to a plurality of photosensitive elements.

The photosensitive element layer 14 may include a plurality of photosensitive elements 1401, 1402, and 1403. The photosensitive element layer 14 may be disposed below the color filter layer 13. The plurality of photosensitive elements 1401, 1402, and 1403 may correspond to the plurality of color filters 1301, 1302, and 1303, respectively. For example, red light input through the color filter 1301 including a red color channel may be collected in a first photosensitive element 1401 corresponding thereto. Green light input through the color filter 1302 including a green color channel may be collected in a second photosensitive element 1402 corresponding thereto. In addition, blue light input through the color filter 1303 including a blue color channel may be collected in a third photosensitive element 1403 corresponding thereto. Alternatively, the plurality of photosensitive elements 1401, 1402, and 1403 may correspond to one color filter. For example, red light input through the color filter 1301 including a red color channel may be collected in the first photosensitive element 1401, the second photosensitive element 1402, and the third photosensitive element 1403 disposed adjacent to each other.

The microlens layer 12 may include a plurality of microlenses 1201, 1202, and 1203. The microlens layer 12 may be disposed above the color filter layer 13. The plurality of microlenses 1201, 1202, and 1203 may be disposed corresponding to the plurality of color filters 1301, 1302, and 1303, respectively. That is, one microlens may be disposed corresponding to one color filter. Alternatively, one microlens may be disposed corresponding to a plurality of color filters. As an example, the color filter layer 13 may be configured such that a plurality of color filters including the same color channel are disposed to form an area. One microlens may be disposed corresponding to the plurality of color filters including the same color channel. Alternatively, when one color filter is disposed to include a plurality of adjacent pixels, one microlens may be disposed corresponding to one color filter including the plurality of pixels.

The microlens layer 12 may transmit light refracted by the lens 11 to the photosensitive element layer 14 through the color filter layer 13. In order for respective microlens 1201, 1202, and 1203 included in the microlens layer 12 to transmit the maximum amount of light to the photosensitive element layer 14, a focus of light refracted by the lens 11 is to be formed in a pixel portion (e.g., the photosensitive element layer 14), which is a photosensitive area, through the microlens layer 12.

As described above, focal lengths of light may vary depending on wavelengths, and focal lengths of light may vary depending on characteristics (e.g., a shape or a physical property) of the lens 11. Therefore, when heights of the plurality of microlenses 1201, 1202, and 1203 are the same, microlenses with unmatched focal lengths may exist depending on characteristics of the lens 11 and wavelengths of light. As an example, a focus of red light may be formed to match a first microlens 1201 disposed on an upper side of a red color filter 1301. The focus being matched with a microlens may mean that the microlens is positioned such that light passing through the microlens is focused on a photosensitive element. However, a focus of green light may not match a second microlens 1202 disposed on an upper side of a green color filter 1302, and may be formed at a position farther than the position of the second microlens 1202. Alternatively, a focus of blue light may not match a third microlens 1203 disposed on an upper side of a blue color filter 1303, and may be formed at a position nearer than the position of the third microlens 1203.

Therefore, the plurality of microlenses 1201, 1202, and 1203 of the disclosure may be configured to have different heights so as to match focal lengths of color channels of light corresponding to the color filters 1301, 1302, and 1303 based on chromatic aberration (e.g., axial chromatic aberration) data according to the color channels of light incident on the lens 11. For example, the chromatic aberration data may be characteristic data of the lens 11 with respect to wavelengths of light corresponding to the color channels, and may be a difference value between reference data and wavelength data of light corresponding to each color channel passing through the lens 11 at the same position. The reference data may be wavelength data of light corresponding to each color channel not affected by external influence.

The chromatic aberration data may vary depending on characteristics of the lens 11, color channels (or wavelengths) of light, and/or positions of the microlenses 1201, 1202, and 1203 on a plane. Heights of the plurality of microlenses 1201, 1202, and 1203 may be configured based on values obtained by inverse compensation of chromatic aberration according to color channels of light of chromatic aberration data. Alternatively, the plurality of microlenses 1201, 1202, and 1203 may include different refractive indices considering color channels of light and configured heights of the microlenses so that light passing through the microlenses may be focused on photosensitive elements.

In addition, each of the plurality of microlenses 1201, 1202, and 1203 may be moved to and disposed at a position corresponding to a chief ray angle (CRA) according to a position of the photosensitive element layer 14. Alternatively, as described above, the plurality of microlenses 1201, 1202, and 1203 may include different refractive indices according to color channels. For example, the microlens 1201 corresponding to a red channel may include a first refractive index, the microlens 1202 corresponding to a green channel may include a second refractive index, and the microlens 1203 corresponding to a blue channel may include a third refractive index. In this case, the plurality of microlenses 1201, 1202, and 1203 may be moved to and disposed on a plane based on the CRA according to the position of the photosensitive element layer 14 and the refractive indices of the microlenses 1201, 1202, and 1203 with respect to a central area of the photosensitive elements 1401, 1402, and 1403.

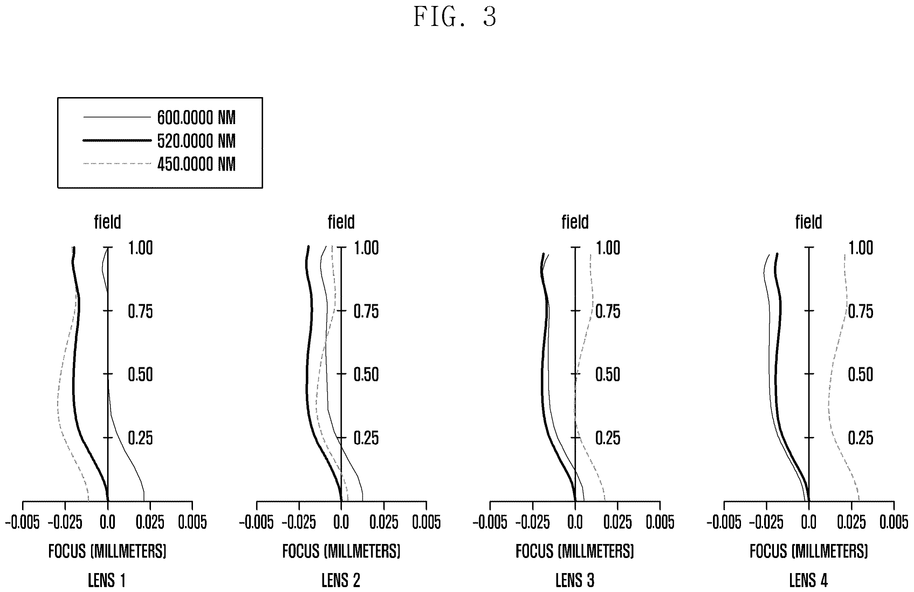

FIG. 3 is a diagram illustrating chromatic aberration due to a lens and color channels according to various embodiments.

Referring to FIG. 3, chromatic aberration data according to characteristics of the lens 11, a field, and color channels is illustrated. The chromatic aberration data may be data related to focal lengths. The field may be a distance in an outward direction from a central point of the lens 11. The characteristics of the lens 11 may include a radius of curvature and/or a material. Chromatic aberration of light of each color channel may vary depending on characteristics of the lens 11 and/or color channels of light. As an example, at the central point of Lens 1, chromatic aberration of a red channel may be about 0.025 mm, chromatic aberration of a green channel may be about 0 mm, and chromatic aberration of a blue channel may be about -0.0125 mm. When other conditions are the same, at the central point of Lens 2, chromatic aberration of a red channel may be about 0.0125 mm, chromatic aberration of a green channel may be about 0 mm, and chromatic aberration of a blue channel may be about 0.005 mm.

In addition, chromatic aberration may vary depending on the field with respect to the central point of the lens 11. As an example, at the central point of Lens 3, chromatic aberration of a blue channel may be about 0.02 mm, at a 0.5 field point, chromatic aberration of the blue channel may be about 0.001 mm, and at a 0.75 field point, chromatic aberration of the blue channel may be about 0.0125 mm.

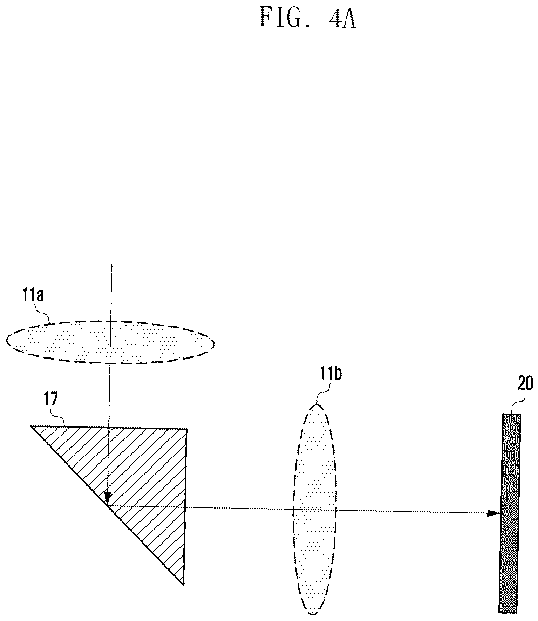

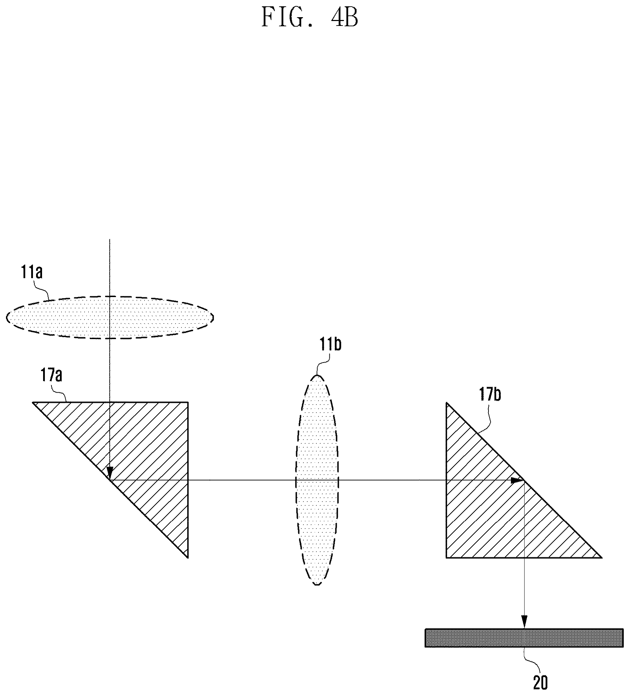

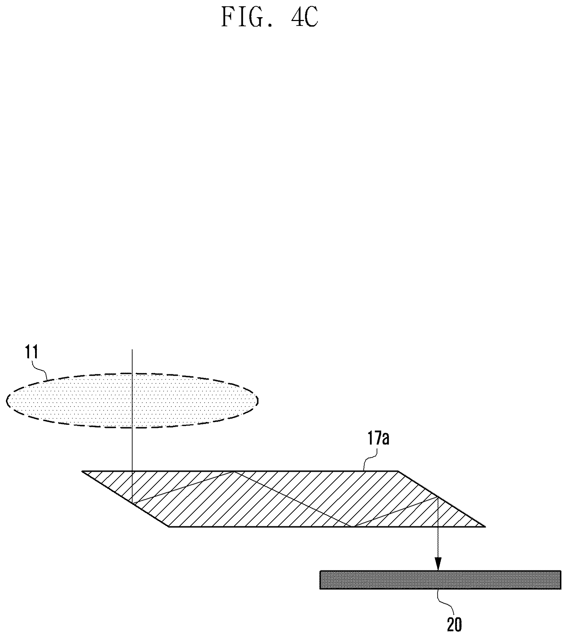

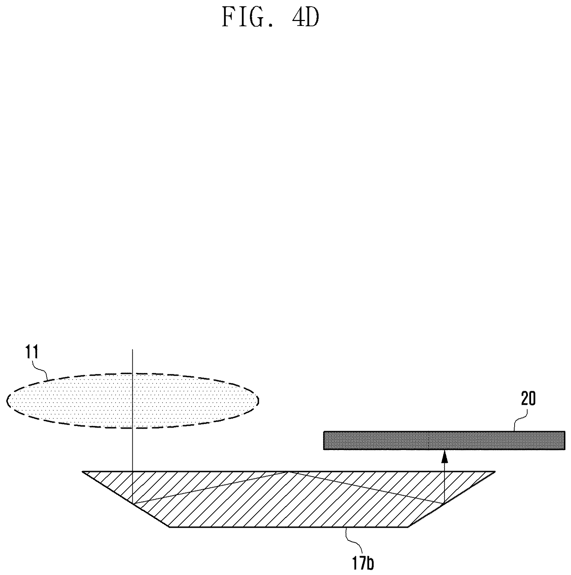

FIGS. 4A, 4B, 4C, and 4D are diagrams illustrating structures of a camera according to various embodiments. The camera 180 may further include a prism depending on its structure, and may include a plurality of lenses and/or a plurality of prisms. The prism may deflect a path of light incident on the camera 180.

Referring to FIG. 4A, a structure in which a path of light incident on the camera 180 is deflected by 90 degrees is illustrated. For example, the camera 180 may deflect a path of light incident vertically to a horizontal direction by 90 degrees using a prism 17. The camera 180 may include one or more lenses 11a and 11b. As an example, when the camera 180 includes two lenses 11a and 11b, along the path of incident light, a first lens 11a (e.g., an objective lens), the prism 17, a second lens 11b, and an image sensor 20 may be disposed. The camera 180 may include one lens. When the camera 180 includes the first lens 11a, along the path of incident light, the first lens 11a (e.g., an objective lens), the prism 17, and the image sensor 20 may be disposed. Alternatively, when the camera 180 includes the second lens 11b, along the path of incident light, the prism 17, the second lens 11b, and the image sensor 20 may be disposed.

Referring to FIG. 4B, a structure in which a path of light incident on the camera 180 is deflected twice by 90 degrees is illustrated. The camera 180 may deflect a path of light incident vertically to a horizontal direction by 90 degrees using a first prism 17a. The camera 180 may deflect the light deflected to the horizontal direction by 90 degrees, again to a vertical direction by 90 degrees using a second prism 17b. The camera 180 may include one or more lenses 11a and 11b. As an example, when the camera 180 includes two lenses 11a and 11b, along the path of incident light, a first lens 11a (e.g., an objective lens), the first prism 17a, a second lens 11b, the second prism 17b, and the image sensor 20 may be disposed. The camera 180 may include one lens. When the camera 180 includes the first lens 11a, along the path of incident light, the first lens 11a (e.g., an objective lens), the first prism 17a, the second prism 17b, and the image sensor 20 may be disposed. Alternatively, when the camera 180 includes the second lens 11b, along the path of incident light, the first prism 17a, the second lens 11b, the second prism 17b, and the image sensor 20 may be disposed.

Referring to FIGS. 4C and 4D, a structure of the camera 180 including polygonal prisms 17a and 17b is illustrated. For example, the camera 180 may include a lens 11 (e.g., an objective lens), the polygonal prisms 17a and 17b, and an image sensor 20 sequentially along a path of light. The polygonal prisms 17a and 17b may totally reflect incident light and output the light in the same direction as the incident direction on a surface opposite to an incident surface (e.g., FIG. 4C), or output the light in an opposite direction to the incident direction on the same surface as the incident surface (e.g., FIG. 4D).

When the camera 180 includes at least one prism and/or a plurality of lenses, chromatic aberration may differ depending on each prism and lens. In this case, chromatic aberration data for correcting chromatic aberration may be a difference value between reference data and wavelength data of light corresponding to each color channel passing through the lens and one or more prisms at the same position. In addition, heights of the plurality of microlenses 1201, 1202, and 1203 may be configured based on values obtained by inverse compensation of chromatic aberration according to color channels of light of the chromatic aberration data.

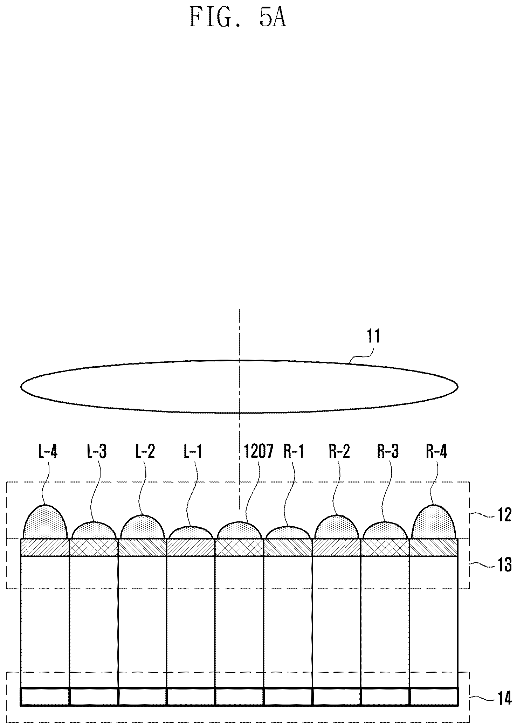

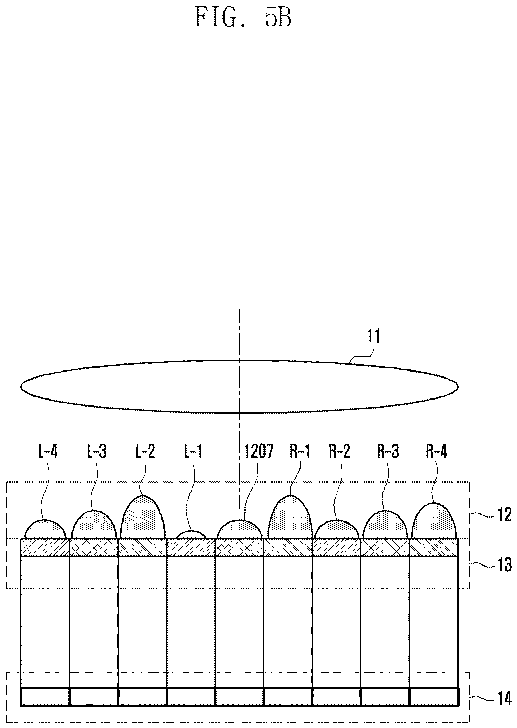

FIGS. 5A and 5B are views illustrating microlenses for correcting axial chromatic aberration according to various embodiments.

Referring to FIGS. 5A and 5B, a lens 11, a microlens layer 12, a color filter layer 13, and a photosensitive element layer 14 are illustrated. The microlens layer 12 may include a plurality of microlenses. In order to correct axial chromatic aberration, heights of the microlenses may be configured (or modified, corrected, compensated, or tuned) to different heights so as to match focal lengths of color channels of light corresponding to the color filters based on chromatic aberration data. For example, heights of the microlenses may be configured based on values obtained by inverse compensation of chromatic aberration of color channels of light of the chromatic aberration data.

As an example, the lens 11 of FIG. 5A may correspond to Lens 1 of the chromatic aberration data in FIG. 3, and a color filter 1207 of a first green channel may be disposed at a central point of Lens 1. To the left of the color filter 1207 of the first green channel, a color filter of red channel L-1, a color filter of green channel L-2, a color filter of red channel L-3, and a color filter of green channel L-4 may be sequentially disposed. In addition, to the right of the color filter 1207 of the first green channel, a color filter of red channel R-1, a color filter of green channel R-2, a color filter of red channel R-3, and a color filter of green channel R-4 may be sequentially disposed. When an interval between respective color filters is about 0.25 mm, from a reference height (or initial height, uncorrected height, or uncompensated height) of each color filter, the color filter of red channel L-1 may be compensated by about -0.01 mm, the color filter of green channel L-2 may be compensated by about +0.02 mm, the color filter of red channel L-3 may be compensated by about 0 mm, and the color filter of green channel L-4 may be compensated by about +0.017 mm. In addition, from the reference height of each color filter, the color filter of red channel R-1 may be compensated by about -0.01 mm, the color filter of green channel R-2 may be compensated by about +0.02 mm, the color filter of red channel R-3 may be compensated by about 0 mm, and the color filter of green channel R-4 may be compensated by about +0.017 mm.

Alternatively, as illustrated in FIG. 5B, a color filter 1207 of a first green channel may be disposed at a central point of the lens 11. To the left of the color filter 1207 of the first green channel, a color filter of red channel L-1, a color filter of blue channel L-2, a color filter of green channel L-3, and a color filter of red channel L-4 may be sequentially disposed. In addition, to the right of the color filter 1207 of the first green channel, a color filter of blue channel R-1, a color filter of red channel R-2, a color filter of green channel R-3, and a color filter of blue channel R-4 may be sequentially disposed. From a reference height of each color filter, the color filter of red channel L-1 may be compensated by about -0.01 mm, the color filter of blue channel L-2 may be compensated by about +0.025 mm, the color filter of green channel L-3 may be compensated by about +0.017 mm, and the color filter of red channel L-4 may be compensated by about 0 mm. In addition, from the reference height of each color filter, the color filter of blue channel R-1 may be compensated by about +0.025 mm, the color filter of red channel R-2 may be compensated by about 0 mm, the color filter of green channel R-3 may be compensated by about +0.017 mm, and the color filter of blue channel R-4 may be compensated by about +0.02 mm.

The heights of the respective color filters as described above may be configured (or compensated, corrected, or modified) to different heights based on chromatic aberration data according to characteristics of the lens 11, color channels, and/or positions on a plane (or distances from the central point of the lens).

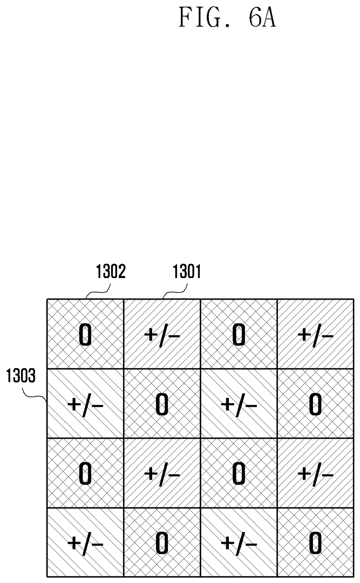

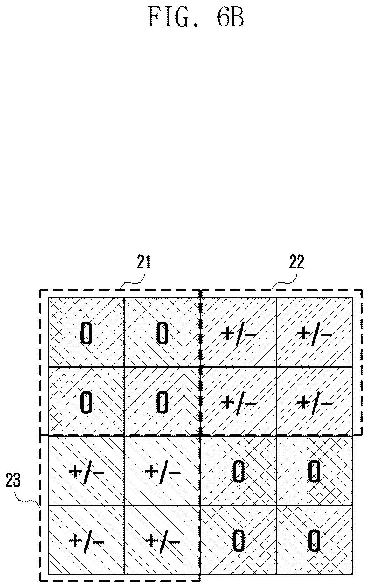

FIGS. 6A and 6B are views illustrating an arrangement of color filters according to various embodiments.

Referring to FIG. 6A, a color filter layer 13 in which color filters 1301, 1302, and 1303 including different color channels are disposed adjacent to each other is illustrated. The color filter layer 13 may be configured such that the color filters 1301, 1302, and 1303 including different color channels are disposed adjacent to each other. For example, a color filter 1301 including a red channel may be disposed on one side of a color filter 1302 including a green channel, and a color filter 1303 including a blue channel may be disposed on the other side. In this case, one microlens may be disposed corresponding to one color filter. In other words, the number of microlenses may be the same as the number of color filters. When chromatic aberration of a microlens corresponding to the color filter 1302 including the green channel is zero, chromatic aberration of a microlens corresponding to the color filter 1301 including the red channel and/or a microlens corresponding to the color filter 1303 including the blue channel may be positive or negative.

Referring to FIG. 6B, a color filter layer 13 in which a plurality of color filters including the same color channel are disposed adjacent to each other is illustrated. The color filter layer 13 may be configured such that the color filters 1301, 1302, and 1303 including the same multiple color channels are disposed adjacent to each other to form areas 21, 22, and 23 of the color channels. As an example, four color filters including a green channel may be disposed adjacent to each other to form a green channel area 21, four color filters including a red channel may be disposed adjacent to each other to form a red channel area 22, and four color filters including a blue channel may be disposed adjacent to each other to form a blue channel area 23. Alternatively, one color filter including a green channel may be configured to form four pixels, one color filter including a red channel may be configured to form four pixels, and one color filter including a blue channel may be configured to form four pixels. In this case, one microlens may be disposed corresponding to one color filter or may be disposed corresponding to one color filter area. For example, when one microlens is disposed corresponding to one color filter, the image sensor may include n microlenses corresponding to n color filters. Alternatively, when one microlens is disposed corresponding to one color filter area, one microlens may be disposed corresponding to one color filter area formed by m color filters. When chromatic aberration of a microlens corresponding to the green channel area 21 is zero, chromatic aberration of a microlens corresponding to the red channel area 22 and/or a microlens corresponding to the blue channel area 23 may be positive or negative.

So far, various examples of correcting axial chromatic aberration in which focal lengths vary depending on refractive indices have been described. Hereinafter, various examples of correcting longitudinal chromatic aberration will be described.

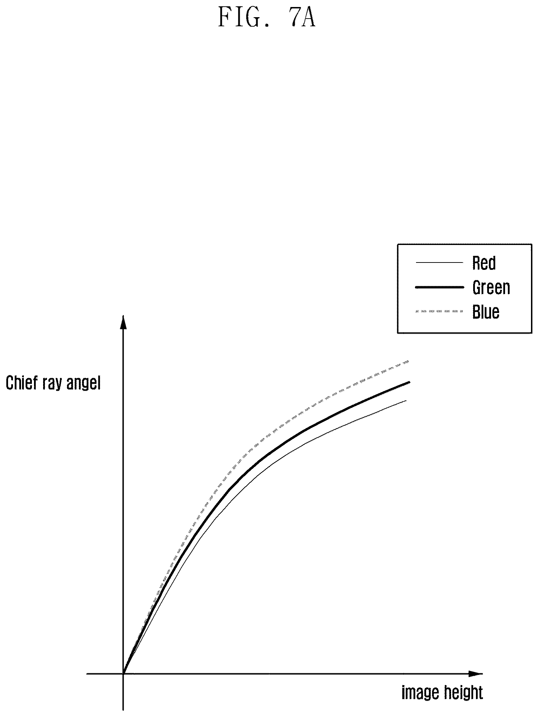

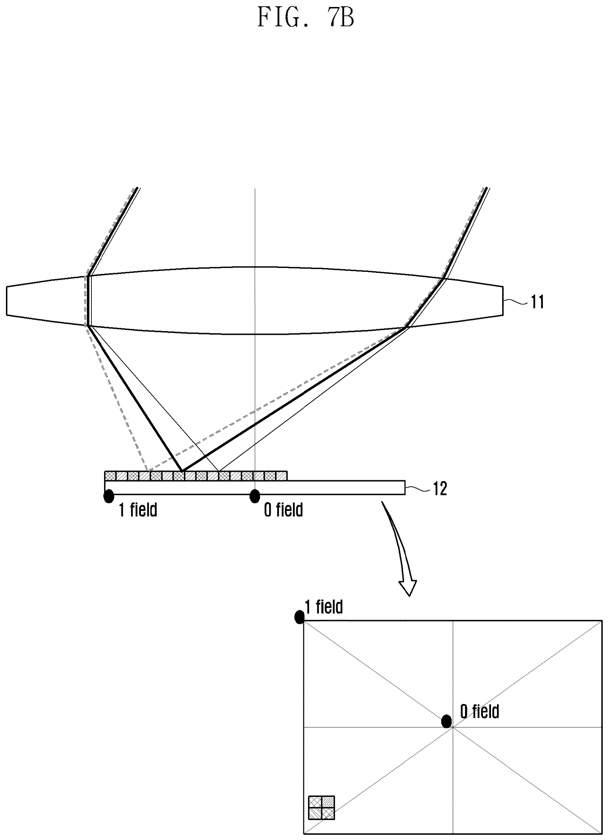

FIGS. 7A and 7B are views illustrating longitudinal chromatic aberration according to various embodiments.

FIG. 7A illustrates a relationship between a distance between a lens 11 and a microlens layer 12 and a chief ray angle (CRA). As the distance between the lens 11 and the microlens layer 12 increases, the CRA may increase. Although CRAs of light of a red channel, a green channel, and a blue channel all increase, an amount of increase may differ depending on the color channel. For example, based on the CRA of green channel light, the CRA of red channel light may be relatively smaller, and the CRA of blue channel light may be relatively greater. Alternatively, depending on a position, structure, and/or design of the lens, based on the CRA of green channel light, the CRA of red channel light may be relatively greater, and the CRA of blue channel light may be relatively smaller.

FIG. 7B illustrates longitudinal chromatic aberration and a correction method. A position at which light passing through the lens 11 is focused may differ with respect to an optical axis. Even when a distance between the lens 11 and the microlens layer 12 is the same, longitudinal chromatic aberration may differ depending on the color channel. The camera may move microlenses to positions corresponding to the CRA in order to correct longitudinal chromatic aberration. For example, depending on the color channel, a position of a corresponding microlens may be moved to a position corresponding to the CRA.

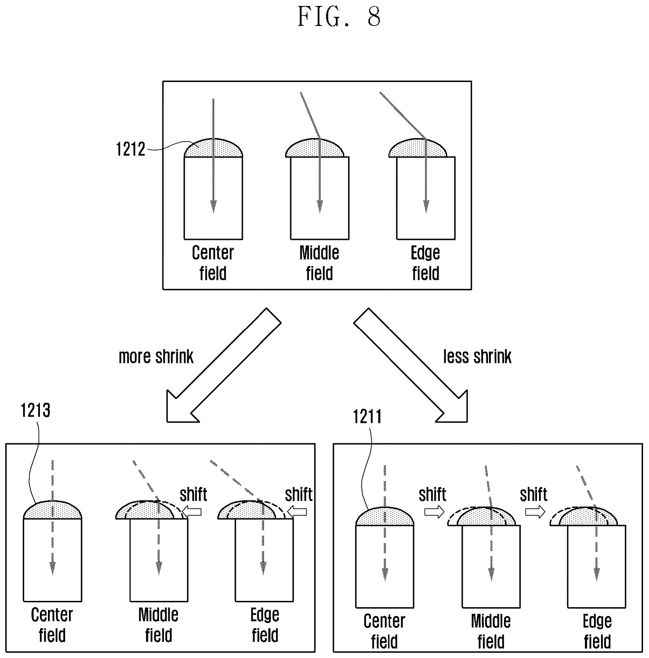

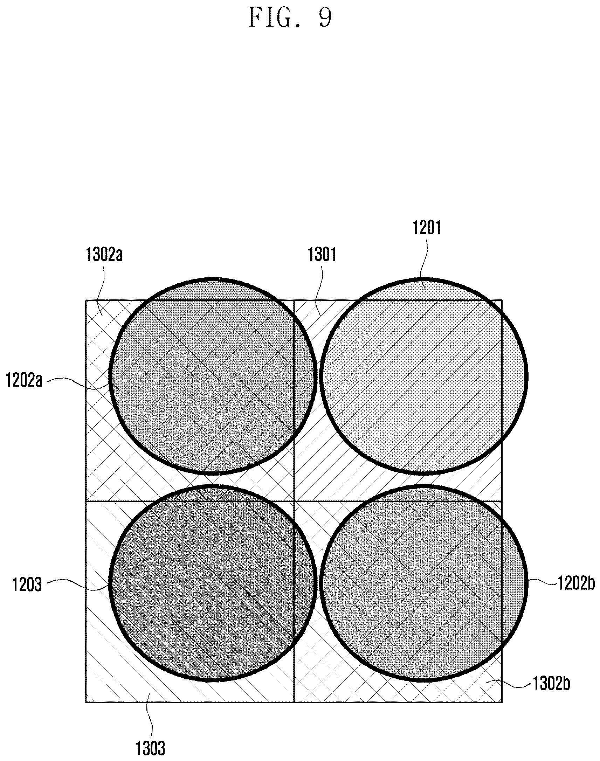

FIGS. 8 and 9 are views illustrating microlenses for correcting longitudinal chromatic aberration according to various embodiments.

Referring to FIG. 8, an example in which positions of microlenses are moved to correct longitudinal chromatic aberration is illustrated. As an example, longitudinal chromatic aberration may mean a degree of deviation of focal positions of other color channels with respect to green channel light. Therefore, a microlens 1212 corresponding to the green channel of a center field of the lens 11 may be disposed at a normal position (or may not be moved). A microlens 1212 corresponding to the green channel of a middle field between the center field and an edge field of the lens 11 may be moved by a relatively small amount to a position corresponding to the CRA. A microlens 1212 corresponding to the green channel of the edge field of the lens 11 may be moved by a relatively large amount to a position corresponding to the CRA. The amounts of movement of the microlenses may be calculated based on CRA graphs for respective color channels illustrated in FIG. 7A, and longitudinal chromatic aberration may be compensated using reciprocals of the CRA values.

Similar to the microlens 1212 corresponding to the green channel, a microlens 1211 corresponding to the red channel and/or a microlens 1213 corresponding to the blue channel may also compensate for longitudinal chromatic aberration. For example, since the CRA of red channel light is relatively smaller compared to the CRA of green channel light, the microlens 1211 corresponding to the red channel in each region of the lens (e.g., the middle field, the edge field) may be moved by a relatively small amount with respect to the normal position. Referring to FIG. 8, when considering amounts of movement with reference to a position compensating for longitudinal chromatic aberration of the microlens 1212 corresponding to the green channel, the microlens 1211 corresponding to the red channel may be moved in an opposite direction relative to the movement position of the microlens 1212 corresponding to the green channel (less shrink).

In addition, since the CRA of blue channel light is relatively greater with reference to the CRA of green channel light, in each region of the lens (e.g., the middle field and the edge field), a microlens 1213 corresponding to the blue channel may be moved by a relatively larger amount with respect to the normal position. As illustrated in FIG. 8, when considering amounts of movement with reference to the position compensating for longitudinal chromatic aberration of the microlens 1212 corresponding to the green channel, the microlens 1213 corresponding to the blue channel may be further moved in the same direction as the movement position of the microlens 1212 corresponding to the green channel (more shrink). Microlenses in which longitudinal chromatic aberration is corrected based on CRA values according to color channels may transmit light of the color channels to central areas of photosensitive elements.

Referring to FIG. 9, microlenses 1201, 1202a, 1202b, and 1203 moved to positions corresponding to CRAs with reference to the color filters 1301, 1302a, 1302b, and 1303 are illustrated. As an example, when the microlenses 1201, 1202a, 1202b, and 1203 are moved as described with reference to FIG. 8, the microlenses 1201, 1202a, 1202b, and 1203 may be arranged as illustrated in FIG. 9. In some cases, interference may occur among the moved microlenses. Therefore, the microlenses 1201, 1202a, 1202b, and 1203 of the disclosure may include different refractive indices according to color channels. In this case, the microlenses may be moved based on chief ray angles and refractive indices according to color channels so that light may be collected in central areas of photosensitive elements.

For example, since the CRA of blue channel light is relatively greater compared to the CRA of green channel light, the refractive index of the microlens 1203 corresponding to the blue channel may be greater than the refractive indices of the microlenses 1202a and 1202b corresponding to the green channel. In this case, the amount of movement of the microlens 1203 corresponding to the blue channel may be reduced. Alternatively, the refractive index of the microlens 1201 corresponding to the red channel may be greater than the refractive indices of the microlenses 1202a and 1202b corresponding to the green channel. In this case, the amount of movement of the microlens 1203 corresponding to the red channel may be further reduced or may be moved in an opposite direction. Movement of microlenses for correcting longitudinal chromatic aberration may be reduced or may be in an opposite direction by varying refractive indices of the microlenses according to color channels. By varying the refractive indices of the microlenses according to color channels, interference between the moved microlenses may be prevented.

The camera 180 (e.g., the camera module 180 of FIG. 1) of the disclosure may be included in an electronic device (e.g., the electronic device 101 of FIG. 1). In addition, the electronic device 101 may include a processor (e.g., the processor 120 of FIG. 1). The processor may control the camera 180 to capture an image.

For example, the image sensor 20 may include a color filter layer 13 including a plurality of color filters 1301, 1302, and 1303 including at least one color channel, the plurality of color filters 1301, 1302, and 1303 being disposed on one plane of the image sensor 20, a microlens layer 12 disposed on an upper side of the color filter layer 13 and including a plurality of microlenses 1201, 1202, and 1203, and a photosensitive element layer 14 including a plurality of photosensitive elements 1401, 1402, and 1403 corresponding to the plurality of color filters 1301, 1302, and 1303. The plurality of microlenses 1201, 1202, and 1203 may be configured to have different heights so as to match focal lengths of color channels of light corresponding to the color filters based on chromatic aberration data according to the color channels of light.

For example, each of the plurality of microlenses 1201, 1202, and 1203 may have a height configured based on a value obtained by inverse compensation of chromatic aberration according to the color channels of light of the chromatic aberration data.

For example, the chromatic aberration data may be characteristic data of the lens 11 with respect to a wavelength of light corresponding to the color channels, and may be a difference value between reference data and wavelength data of light corresponding to each color channel passing through the lens 11 at the same position.

For example, the characteristic data of the lens 11 may be determined by at least one of a shape and a physical property of the lens 11.

For example, the plurality of microlenses 1201, 1202, and 1203 may include different refractive indices so as to match focal lengths of the color channels of light based on the color channels of light and configured heights of the microlenses.

For example, the color filter layer 13 may be configured such that the color filters including different color channels are disposed adjacent to each other.

For example, the microlens layer 12 may be configured such that one microlens is disposed corresponding to one color filter.

For example, the color filter layer 13 may be configured such that color filters including a predetermined number of the same color channels are disposed adjacent to each other.

For example, the color filter layer 13 may be configured such that one color filter includes a plurality of pixels disposed adjacent to each other.

For example, the microlens layer 12 may be configured such that one microlens is disposed corresponding to one color filter including the plurality of pixels.

For example, each of the plurality of microlenses 1201, 1202, and 1203 may be moved to and disposed at a position corresponding to a chief ray angle (CRA) according to a position of the photosensitive element layer.

For example, the plurality of microlenses 1201, 1202, and 1203 may include different refractive indices according to the color channels. Each of the plurality of microlenses 1201, 1202, and 1203 may be moved to and disposed on a plane based on a chief ray angle (CRA) according to a position of the photosensitive element layer 14 and the refractive indices with respect to a central area of the photosensitive elements.

For example, a camera 180 may include a lens 11 and an image sensor 20. The image sensor 20 may include a color filter layer 13 including a plurality of color filters 1301, 1302, and 1303 including at least one color channel, the plurality of color filters 1301, 1302, and 1303 being disposed on one plane of the image sensor 20, a microlens layer 12 disposed on an upper side of the color filter layer 13 and including a plurality of microlenses 1201, 1202, and 1203, and a photosensitive element layer 14 including a plurality of photosensitive elements 1401, 1402, and 1403 corresponding to the plurality of color filters 1301, 1302, and 1303. The plurality of microlenses 1201, 1202, and 1203 may be configured to have different heights so as to match focal lengths of color channels of light corresponding to the color filters based on chromatic aberration data according to the color channels of light incident through the lens 11.

For example, each of the plurality of microlenses 1201, 1202, and 1203 may have a height configured based on a value obtained by inverse compensation of chromatic aberration according to the color channels of light of the chromatic aberration data.

For example, the camera 180 may further include at least one prism 17 for changing the path of the light.

For example, the chromatic aberration data may be a difference value between reference data and wavelength data of light corresponding to each color channel passing through the lens 11 and the at least one prism 17 at the same position.

For example, the plurality of microlenses 1201, 1202, and 1203 may include different refractive indices so as to match focal lengths of the color channels of light based on the color channels of light and configured heights of the microlenses.

For example, each of the plurality of microlenses 1201, 1202, and 1203 may be moved to and disposed at a position corresponding to a chief ray angle (CRA) according to a position of the photosensitive element layer 14.

For example, the plurality of microlenses 1201, 1202, and 1203 may include different refractive indices according to the color channels. Each of the plurality of microlenses 1201, 1202, and 1203 may be moved to and disposed on a plane based on a chief ray angle (CRA) according to a position of the photosensitive element layer 14 and the refractive indices with respect to a central area of the plurality of photosensitive elements.

For example, an electronic device 101 may include a camera 180 and at least one processor 120 configured to control the camera 180. The camera 180 may include a lens 11 and an image sensor 20. The image sensor 20 may include a color filter layer 13 including a plurality of color filters 1301, 1302, and 1303 including at least one color channel, the plurality of color filters 1301, 1302, and 1303 being disposed on one plane of the image sensor 20, a microlens layer 12 disposed on an upper side of the color filter layer 13 and including a plurality of microlenses 1201, 1202, and 1203, and a photosensitive element layer 14 including a plurality of photosensitive elements 1401, 1402, and 1403 corresponding to the plurality of color filters 1301, 1302, and 1303. The plurality of microlenses 1201, 1202, and 1203 may be configured to have different heights so as to match focal lengths of color channels of light corresponding to the color filters based on chromatic aberration data according to the color channels of light incident through the lens 11.

It should be appreciated that various examples of the disclosure and the terms used therein are not intended to limit the technological features set forth herein to particular examples and include various changes, equivalents, or replacements for a corresponding example. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it denotes that the element may be coupled with the other element directly (e.g., wiredly), wirelessly, or via a third element.

As used in connection with various examples of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an example, the module may be implemented in a form of an application-specific integrated circuit (ASIC).

Various examples as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an example, a method according to various examples of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various examples, each component (e.g., a module or a program) of the above-described components may include a single entity or multiple entities, and some of the multiple entities may be separately disposed in different components. According to various examples, one or more of the above-described components may be omitted, or one or more other components may be added. Alternatively or additionally, a plurality of components (e.g., modules or programs) may be integrated into a single component. In such a case, according to various examples, the integrated component may still perform one or more functions of each of the plurality of components in the same or similar manner as they are performed by a corresponding one of the plurality of components before the integration. According to various examples, operations performed by the module, the program, or another component may be carried out sequentially, in parallel, repeatedly, or heuristically, or one or more of the operations may be executed in a different order or omitted, or one or more other operations may be added.

The effects of the disclosure are not limited to those mentioned above, and other effects not mentioned will be clearly understood by those skilled in the art from the above description.

**Claims**

1. An image sensor comprising:

   a color filter layer comprising a plurality of color filters comprising at least one color channel, the plurality of color filters being disposed on one plane of the image sensor;
   a microlens layer disposed on an upper side of the color filter layer and comprising a plurality of microlenses; and

a photosensitive element layer comprising a plurality of photosensitive elements corresponding to the plurality of color filters,
wherein the plurality of microlenses are configured to have different heights so as to match focal lengths of the color channels of light corresponding to the color filters based on chromatic aberration data according to the color channels of light.

2. The image sensor of claim 1, wherein each of the plurality of microlenses has a height configured based on a value obtained by inverse compensation of chromatic aberration according to the color channels of light of the chromatic aberration data.

3. The image sensor of claim 1, wherein the chromatic aberration data is characteristic data of a lens with respect to a wavelength of light corresponding to the color channels, or characteristic data of a lens and a prism, and is a difference value between reference data and wavelength data of light corresponding to each color channel passing through at least one of the lens and the prism at the same position.

4. The image sensor of claim 3, wherein the characteristic data of the lens is determined by at least one of a shape and a physical property of the lens.

5. The image sensor of claim 1, wherein the plurality of microlenses comprise different refractive indices so as to match the focal lengths of the color channels of light based on the color channels of light and the configured heights of the microlenses.

6. The image sensor of claim 1, wherein the color filter layer is configured such that color filters comprising different color channels are disposed adjacent to each other.

7. The image sensor of claim 6, wherein the microlens layer is configured such that one microlens is disposed corresponding to one color filter.

8. The image sensor of claim 1, wherein the color filter layer is configured such that color filters comprising a predetermined number of same color channels are disposed adjacent to each other.

9. The image sensor of claim 1, wherein the color filter layer is configured such that one color filter comprises a plurality of pixels disposed adjacent to each other.

10. The image sensor of claim 9, wherein the microlens layer is configured such that one microlens is disposed corresponding to one color filter comprising the plurality of pixels.

11. The image sensor of claim 1, wherein each of the plurality of microlenses is moved to and disposed at a position corresponding to a chief ray angle (CRA) according to a position of the photosensitive element layer.

12. The image sensor of claim 11, wherein the plurality of microlenses comprise different refractive indices according to the color channels, and
wherein each of the plurality of microlenses is moved to and disposed on a plane based on the chief ray angle (CRA) according to the position of the photosensitive element layer and the refractive indices with respect to a central area of the photosensitive elements.

13. A camera comprising:

a lens; and
an image sensor,
wherein the image sensor comprises:

a color filter layer comprising a plurality of color filters comprising at least one color channel, the plurality of color filters being disposed on one plane of the image sensor;
a microlens layer disposed on an upper side of the color filter layer and comprising a plurality of microlenses; and
a photosensitive element layer comprising a plurality of photosensitive elements corresponding to the plurality of color filters, and
wherein the plurality of microlenses are configured to have different heights so as to match focal lengths of the color channels of light corresponding to the color filters based on chromatic aberration data according to the color channels of light incident through the lens.

14. The camera of claim 13, wherein each of the plurality of microlenses has a height configured based on a value obtained by inverse compensation of chromatic aberration according to the color channels of light of the chromatic aberration data.

15. An electronic device comprising:

a camera; and
at least one processor configured to control the camera,
wherein the camera comprises:

a lens; and
an image sensor,
wherein the image sensor comprises:

a color filter layer comprising a plurality of color filters and at least one color channel, the plurality of color filters being disposed on one plane of the image sensor;

a microlens layer disposed on an upper side of the color filter layer and comprising a plurality of microlenses; and

a photosensitive element layer comprising a plurality of photosensitive elements corresponding to the plurality of color filters, and

wherein the plurality of microlenses are configured to have different heights so as to match focal lengths of the color channels of light corresponding to the color filters based on chromatic aberration data according to the color channels of light incident through the lens.

## FIG. 1

EP 4 716 230 A1

# FIG. 2

FIG. 3

FIG. 4A

# FIG. 4B

FIG. 4C

FIG. 4D

# FIG. 5A

L-4   L-3   L-2   L-1   1207   R-1   R-2   R-3   R-4

11

12

13

14

# FIG. 5B

L-4 L-3 L-2 L-1 1207 R-1 R-2 R-3 R-4

11

12

13

14

# FIG. 6A

# FIG. 6B

FIG. 7A

# FIG. 7B

# FIG. 8

# FIG. 9

## INTERNATIONAL SEARCH REPORT

| International application No. |
| --- |
| **PCT/KR2023/014910** |

**A. CLASSIFICATION OF SUBJECT MATTER**

**H04N 25/611**(2023.01)i; **H04N 25/13**(2023.01)i; **H04N 23/54**(2023.01)i; **H04N 23/55**(2023.01)i; **H01L 27/146**(2006.01)i

According to International Patent Classification (IPC) or to both national classification and IPC

**B. FIELDS SEARCHED**

Minimum documentation searched (classification system followed by classification symbols)

H04N 25/611(2023.01); B60R 1/00(2006.01); G02B 3/00(2006.01); H01L 27/146(2006.01); H04N 5/232(2006.01); H04N 5/335(2011.01); H04N 5/3745(2011.01); H04N 5/376(2011.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 색수차(chromatic aberration), 초점(focus), 높이(height), 렌즈(lens), 이미지 센서 (image sensor)

**C. DOCUMENTS CONSIDERED TO BE RELEVANT**

| Category* | Citation of document, with indication, where appropriate, of the relevant passages | Relevant to claim No. |
| --- | --- | --- |
| X<br><br>Y | DE 10-2019-218065 A1 (ZF FRIEDRICHSHAFEN AG) 27 May 2021 (2021-05-27)<br>See paragraphs [0011]-[0036] and figure 4. | 1,2,5-7,13-15<br><br>3,4,8-12 |
| Y | JP 2021-034774 A (CANON INC.) 01 March 2021 (2021-03-01)<br>See paragraph [0041] and figure 8. | 3,4 |
| Y | KR 10-2023-0020857 A (SK HYNIX INC.) 13 February 2023 (2023-02-13)<br>See paragraphs [0098]-[0126] and figure 5. | 8,11,12 |
| Y | KR 10-2022-0127003 A (SAMSUNG ELECTRONICS CO., LTD.) 19 September 2022 (2022-09-19)<br>See paragraph [0054] and figure 8. | 9,10 |

☑ Further documents are listed in the continuation of Box C. ☑ See patent family annex.

| | |
| --- | --- |
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **11 March 2024** | **11 March 2024** |

| Name and mailing address of the ISA/KR | Authorized officer |
| --- | --- |
| **Korean Intellectual Property Office**<br>**Government Complex-Daejeon Building 4, 189 Cheongsa-**<br>**ro, Seo-gu, Daejeon 35208** | |
| Facsimile No. **+82-42-481-8578** | Telephone No. |

Form PCT/ISA/210 (second sheet) (July 2022)

**EP 4 716 230 A1**

**INTERNATIONAL SEARCH REPORT**

| International application No. |
| --- |
| **PCT/KR2023/014910** |

**C. DOCUMENTS CONSIDERED TO BE RELEVANT**

| Category* | Citation of document, with indication, where appropriate, of the relevant passages | Relevant to claim No. |
| --- | --- | --- |
| A | KR 10-2507184 B1 (KOREA INSTITUTE OF MACHINERY & MATERIALS) 09 March 2023 (2023-03-09)<br>See claims 1-11. | 1-15 |

Form PCT/ISA/210 (second sheet) (July 2022)

**INTERNATIONAL SEARCH REPORT**
Information on patent family members

International application No.

**PCT/KR2023/014910**

| Patent document cited in search report | | | Publication date (day/month/year) | Patent family member(s) | | | Publication date (day/month/year) |
|---|---|---|---|---|---|---|---|
| DE | 10-2019-218065 | A1 | 27 May 2021 | None | | | |
| JP | 2021-034774 | A | 01 March 2021 | None | | | |
| KR | 10-2023-0020857 | A | 13 February 2023 | CN | 115914799 | A | 04 April 2023 |
| | | | | US | 2023-0042186 | A1 | 09 February 2023 |
| KR | 10-2022-0127003 | A | 19 September 2022 | CN | 115084173 | A | 20 September 2022 |
| | | | | US | 2022-0293653 | A1 | 15 September 2022 |
| KR | 10-2507184 | B1 | 09 March 2023 | None | | | |

Form PCT/ISA/210 (patent family annex) (July 2022)